# EUROPEAN PATENT APPLICATION

(11) **EP 1 195 806 A2**
(43) Date of publication of application: **10.04.2002**
(21) Application number: 01123678.3
(22) Date of filing: 02.10.2001
(51) Int. Cl.: H01L 21/56

(54) **Method for underfilling a flip-chip semiconductor device**

(30) Priority: 04.10.2000 JP 2000304399
(71) Applicant: SONY CORPORATION, Tokyo (JP)
(72) Inventor: Yoshida, Koji, Kisarazu-shi, Chiba-ken (JP)
(74) Representative: Müller . Hoffmann & Partner Patentanwälte

(57) **Abstract**

The invention provides a method for manufacturing a semiconductor device for preventing the low bonding strength reliability in flip tip mounting of a semiconductor chip on an organic substrate. In the thermal hardening process for hardening the under fill resin filled between a semiconductor chip and organic substrate. The thermal expansion due to rapid heating of an organic substrate is mitigated by applying multi-step heating process in which under fill resin is heated at a temperature T1 lower than the hardening temperature T2 of the under fill resin for a predetermined time.

## Description

### BACKGROUND OF THE INVENTION

### Field of the Invention

This invention relates to a method for manufacturing a semiconductor device, and more particularly relates to a method for hardening of thermosetting resin filled between a semiconductor chip and a circuit substrate (under fill resin) in mounting of a flip tip of a semiconductor chip.

### Description of the Related Art

Heretofore, the flip tip mounting for mounting a semiconductor chip on a circuit pattern on a circuit substrate with the surface, on which an electrode terminal is to be formed, downward has been disclosed in, for example, Japanese Patent Application Laid Open No. Hei 9-181122 and Japanese Patent Application Laid Open No. Hei 10-321666, and this method has been used widely for manufacturing semiconductor package products such as CSP (Chip Size Package)/BGA (Ball Grid Array) .

In the flip tip mounting, the ultrasonic bonding method has been used most popularly as a method for bonding a terminal of a semiconductor chip to a circuit pattern on a circuit substrate as disclosed in, for example, Japanese Patent No. 2629216. The ultrasonic bonding method is advantageous over other methods such as soldering in that bonding is completed in a short time at a relatively low temperature inexpensively.

On the other hand, the ultrasonic bonding method is disadvantageous over soldering method in that the bonding strength is weak to result in low bonding strength reliability due to the thermal stress of the bonding. The under fill coat treatment in which thermosetting resin is filled between a bonded semiconductor chip and a circuit substrate to mitigate the thermal stress of the bonding has been known (the above-mentioned Japanese Patent No. 2727443 and Japanese Patent Application Laid Open No. Hei 9-181122). The under fill coat treatment has been developed to mitigate the stress arising from mismatching between the thermal expansion coefficient of a semiconductor chip and a circuit substrate, and the load is distributed evenly on the whole chip to prevent the stress concentration on the bonding.

Heretofore, ceramic substrates consisting of material containing mainly inorganic material have been used as the circuit substrate used for flip tip mounting, but circuit substrates consisting of material containing mainly organic materials such as phenol resin, epoxy resin, and polyimide resin have been used though it is in its infancy.

However, the difference of thermal expansion coefficient between a circuit substrate consisting of organic material (referred to as organic substrate hereinafter) and a semiconductor chip is significantly larger than the difference between a circuit substrate consisting of inorganic material (referred to as inorganic substrate hereinafter) and a semiconductor chip. As the result, the stress concentration at the bonding that arises between a semiconductor chip and an organic substrate during thermal hardening process of under fill resin is more serious than that between a semiconductor chip and an inorganic substrate, and the bonding strength reliability is low.

In particular, in the case that a semiconductor chip is bonded to an organic substrate by means of ultrasonic bonding method, the load applied on the substrate side is inevitably low due to lower hardness of the organic substrate in comparison with the inorganic substrate, and the lower hardness results in low bonding strength in comparison with the inorganic substrate and the above-mentioned problem is more serious.

### SUMMARY OF THE INVENTION

The present invention has been accomplished to solve the above-mentioned problem, and provides a method for manufacturing a semiconductor device in which the stress concentration arising at the bonded portion during the thermal hardening process of under fill resin to prevent the poor bonding strength reliability in flip tip mounting of a semiconductor chip on a organic substrate.

To solve the above-mentioned problem, the present invention is characterized by providing a method for manufacturing a semiconductor device comprising a bonding process for bonding a semiconductor chip on a circuit substrate consisting of organic material, a resin injection process for injecting and filling thermosetting resin between the bonded circuit substrate and the semiconductor chip, and a thermal hardening process for heating and hardening the filled thermosetting resin at the hardening temperature, wherein the thermal hardening process involves a process for heating at multi-step temperatures for predetermined times respectively between a temperature lower than the thermal hardening temperature and the hardening temperature.

According to the above-mentioned method, the rapid thermal expansion of a circuit substrate consisting of organic material is suppressed and the stress concentration that acts on the bonding portion between the semiconductor chip and the circuit substrate is mitigated, and as the result it is possible to obtain a semiconductor device of high bonding strength reliability.

As described hereinabove, according to the method for manufacturing a semiconductor device of the present invention, because the thermal expansion due to rapid heating of the circuit substrate consisting of organic material in heat treatment in the thermal hardening process for hardening under fill resin, the deterioration of the bonding strength reliability of the bonding portion between the semiconductor chip and the circuit substrate is prevented, and a low cost semiconductor device that uses a circuit substrate consisting of organic material can be obtained. An organic substrate is made usable without any deterioration of the bonding reliability even for a semiconductor chip having many terminals.

According to another aspect of the present invention, not only the method of the present invention is excellent in productivity in comparison with other bonding methods such as soldering but also the connection resistance is low. As the result, it is possible to apply the method of the present invention to a semiconductor package such as high frequency device.

### BRIEF DESCRIPTION OF THE DRAWINGS

FIG. 1 is a side view showing schematically a semiconductor chip in accordance with an embodiment of the present invention.
FIG. 2 is a partially cutaway side view showing ultrasonic bonding process in accordance with the present invention.
FIG. 3A is a partial cross sectional view showing resin coating process for coating under fill resin in accordance with the present invention.
FIG. 3B is a partial cross sectional view showing coated-resin filling process for filling under fill resin in accordance with the present invention.
FIG. 4 is a side cross sectional view of a semiconductor device that has been subjected to under fill coating.
FIG. 5A is a graph for describing a thermal profile of the thermal hardening process for hardening under fill resin in accordance with the embodiment of the present invention.
FIG. 5B is a graph for describing a conventional thermal profile.
FIG. 6 is a flow chart showing the fabrication process for fabricating a semiconductor device in accordance with the embodiment of the present invention.

### DETAILED DESCRIPTION OF THE PREFERRED EMBODIMENTS

Embodiment of the present invention will be described in detail hereinafter with reference to the drawings.

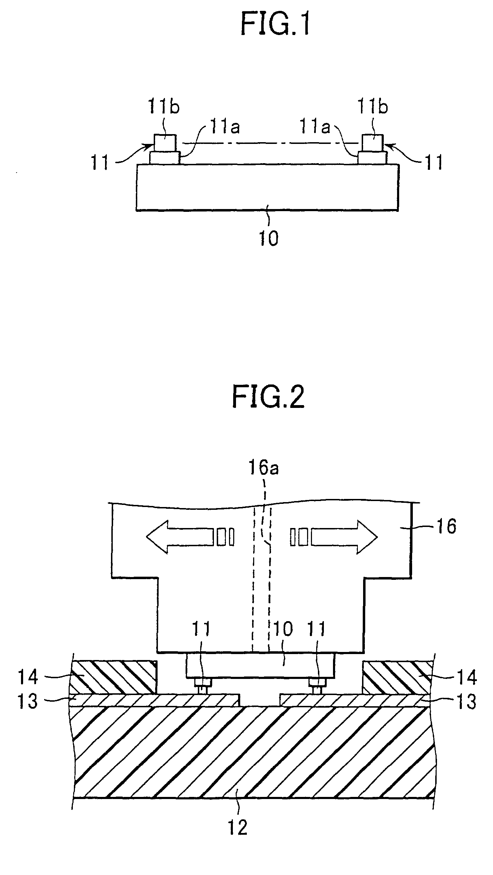

FIG. 1 is a side view showing the configuration of a semiconductor chip in accordance with an embodiment of the present invention. In FIG. 1, a plurality of electrode pads (not shown in the drawing) are formed in grid fashion on the top surface of the semiconductor chip 10, and stud bumps in the form of two-step projection are formed on the respective electrode pads. The number of bumps in the drawings is not so many for the purpose of simple description, but many bumps are formed actually.

In the present embodiment, a bump 11 is formed by means of wire bonding method by use of a gold (Au) wire. At first, the ball-shaped top end of the gold wire is bonded on the electrode pad by means of thermo compression bonding to form the first projection 11a, and a capillary of the wire bonder is moved to form the second projection 11b. The projections are leveled as required to level the height of the bumps thereafter.

Another method for forming bumps 11, in which, for example, a gold plated bump is formed on the electrode pad with interposition of barrier metal, may be used differently from the above-mentioned method.

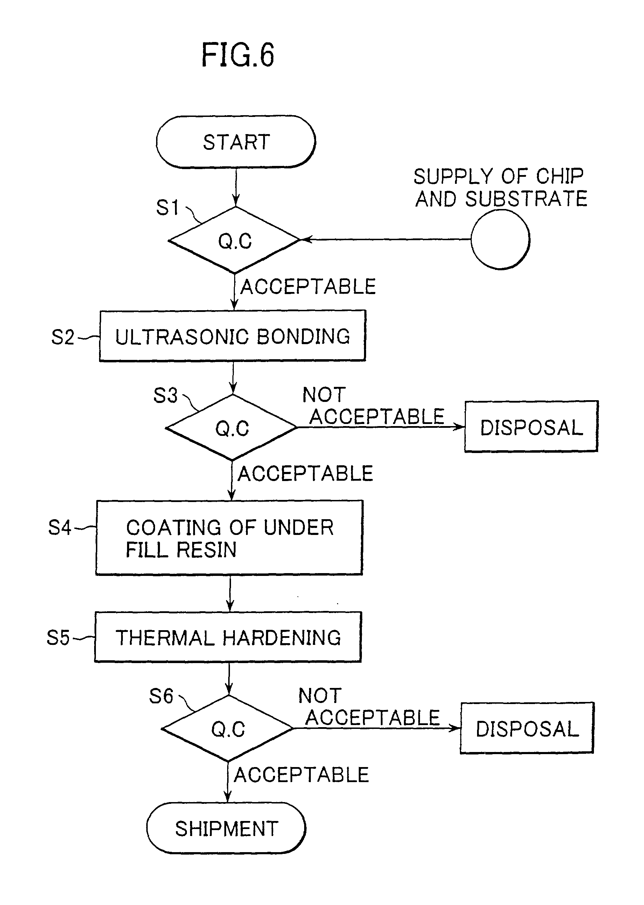

FIG. 6 is a process flow diagram for describing a mounting process for mounting a semiconductor chip 10. The semiconductor chip 10 formed as described hereinabove is then subjected to quality inspection, and supplied to the next process, namely ultrasonic bonding process (steps S1 and S2).

The above-mentioned quality inspection is repeated after the ultrasonic bonding process, which will be described in detail hereinafter, and after thermal hardening process of under fill resin before shipment (steps S3 and S6)

Herein, the circuit substrate 12 (refer to FIG. 2) used in the present embodiment consists of an organic material such as phenol resin, polyester resin, epoxy resin, or polyimide resin having a circuit pattern 13 consisting of a metal such as copper on the surface thereof, and is configured so as to be served as a mother board or an interposer (daughter board) in CSP/BGA.

This circuit substrate 12 is referred to as an organic substrate for the purpose of description.

FIG. 2 shows an ultrasonic bonding process for bonding the semiconductor chip 10 to the organic substrate 12. The semiconductor chip 10 is vacuum-suction held by means of a tool 16 having a hole 16 that is communicated to a vacuum-suction means not shown in the drawing so as that the bump forming plane is directed downward. The tool 16 is connected to an ultrasonic vibration means, and the ultrasonic vibration means vibrates the semiconductor chip 10 that is pressed against the circuit pattern (land) 13 on the organic substrate 12 in the direction shown with arrows in FIG. 2, and the tip end of the second step of the bump 11 is melted with frictional heating and fixed to the wiring pattern 13. In FIG. 2, the character 14 denotes resist that covers the surface of the circuit pattern 13.

As described hereinabove, the semiconductor chip 10 is connected to the organic substrate 12 electrically and mechanically with interposition of the bump 11. After bonding inspection, the bonded product is supplied to the next process, namely under fill resin coating process (steps S3 and S4).

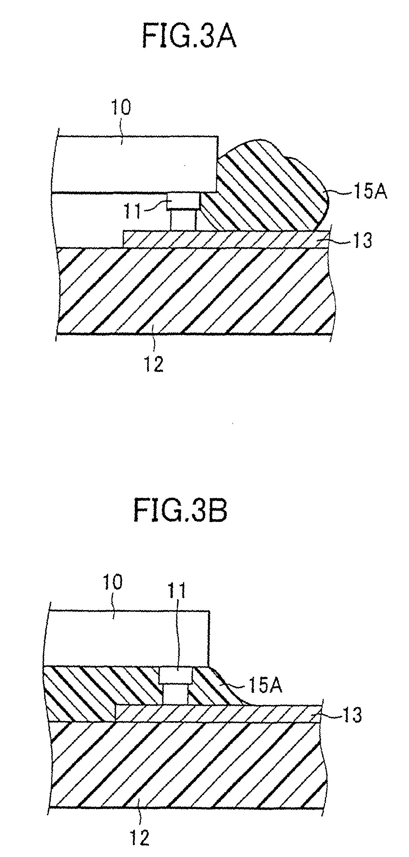

FIG. 3A and FIG. 3B show under fill resin coating process. At first, thermosetting under fill resin 15A is coated on the periphery of the semiconductor chip 10 on the organic substrate 12 (FIG. 3A). In the present embodiment, under fill resin consisting mainly of epoxy resin containing filler is used as the under fill resin 15A. The coated resin 15A that has been penetrated into the gap is filled between the semiconductor chip 10 and the organic substrate 12 with aid of capillary phenomenon (FIG. 3B). Thereafter, the organic substrate 12 is supplied together with the semiconductor chip into a heating furnace not shown in the drawing, and the resin 15A is thermally hardened (step S5).

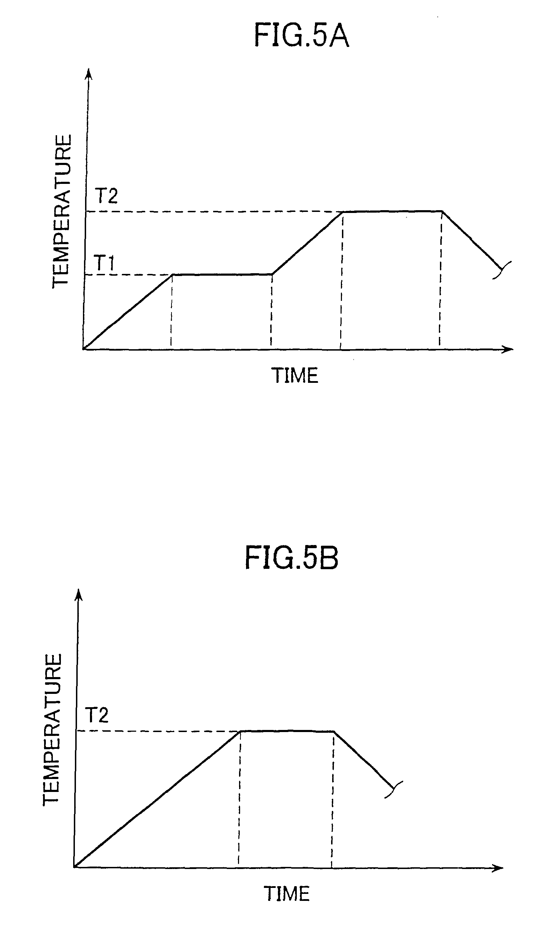

FIG. 5A shows a temperature profile of the heating furnace for thermally hardening the under fill resin 15A filled between the semiconductor chip 10 and the organic substrate 12. As shown in FIG. 5A, the under fill resin 15A is heated at first at a temperature T1 that is lower than the hardening temperature of the resin 15A T2 for a predetermined time and then heated at the hardening temperature T2 in the present embodiment.

An existing heating furnace that is capable to set a heating profile arbitrarily may be used as the heating furnace used in the present embodiment.

During the time period while the temperature rises from a room temperature to the temperature T1, the under fill resin 15A is fluidized the more, penetrates into the gap between the semiconductor chip 10 and the organic substrate 12 deeply and into the narrow areas between bumps 11, and the penetration of the resin 15A into the above-mentioned gaps is improved. Furthermore, the heating at the temperature T1 for a predetermined time prompts the resin molecules to be cross-linked and thermally hardened.

As described hereinbefore, by heating under fill resin 15A at a temperature lower than the hardening temperature for a predetermined time before heating at the hardening temperature, the temperature gradient during heating is made small to suppress the rapid thermal expansion of the organic substrate 12.

As the result, the stress that acts on the bumps 11 that are served for bonding between the semiconductor chip 10 and the organic substrate 12 is reduced, the bumps 11 are prevented from being damaged or separated during thermal hardening process for hardening the under fill resin 15A, and the bonding reliability is maintained high.

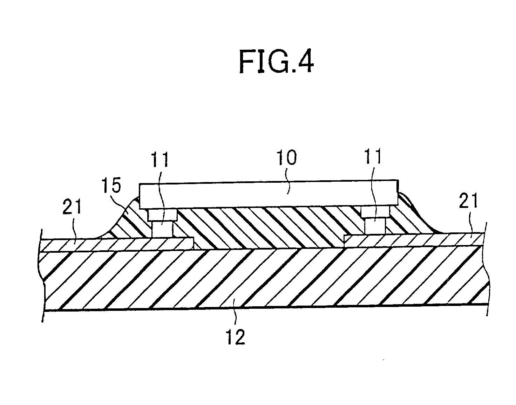

The resin 15A that has been thermally hardened as described hereinabove mitigates the stress due to mismatching of thermal expansion coefficient between the semiconductor chip 10 and the organic substrate 12 as the under fill coat 15 as shown in FIG. 4, and functions to prevent the stress concentration on the boding portion because the stress is distributed over the whole chip.

As described hereinbefore, according to the present embodiment, the thermal expansion of the organic substrate 12 due to rapid heating is mitigated in heat treatment for thermal hardening process of under fill resin to prevent the damage (generation of crack) of the bump 11 and separation of the bump 11 effectively. As the result, the low bonding strength reliability is prevented and the low cost semiconductor device provided with an organic substrate is obtained. Furthermore, it is possible to use an organic substrate without deterioration of the bonding reliability even for a semiconductor chip having many terminals.

In addition to the above, not only the ultrasonic bonding method is excellent in productivity in comparison with other bonding methods such as soldering but also the connection resistance (electrical resistance between the bump 11 and the circuit pattern 13) is low. Therefore, the ultrasonic bonding method can be applied to fabricate a semiconductor package such as high frequency device.

An embodiment of the present invention is described hereinbefore, however, as a matter of course the present invention is by no means limited to the embodiment, and various modifications may be applied based on the technical spirit of the present invention.

For example, a method in which the two-step heat treatment that the under fill resin 15A is heated at a temperature T1 for a predetermined time before heating at the hardening temperature T2 in the thermal hardening profile is described hereinabove, however, as a matter of course the number of heating steps applied before heating at the hardening temperature T2 may be increased, the stress concentrated on the bonding portion is reduced the more, and the bonding strength reliability is improved the more.

## Claims

1. A method for manufacturing a semiconductor device, comprising:
a bonding process for bonding a semiconductor chip on a circuit substrate constituting of organic material;
a resin injection process for injecting and filling thermosetting resin between said bonded circuit substrate and said semiconductor chip; and
a thermal hardening process for heating and hardening said filled thermosetting resin at the hardening temperature,
wherein said thermal hardening process involves a process for heating at multi-step temperatures for predetermined times respectively between a temperature lower than said thermal hardening temperature and said hardening temperature.

2. A method for manufacturing a semiconductor device as claimed in claim 1, wherein said bonding process is ultrasonic bonding process for bonding said semiconductor chip to a circuit pattern on said circuit substrate by means of ultrasonic vibration.
